# EUROPÄISCHE PATENTSCHRIFT

(11) **EP 1 456 992 B1**
(45) Veröffentlichungstag und Bekanntmachung des Hinweises auf die Patenterteilung: **04.05.2005**
(21) Anmeldenummer: 02792669.0
(22) Anmeldetag: 17.12.2002
(51) Int. Cl.: H04L 1/00, H03G 3/30

(54) **SENDEANORDNUNG FÜR ZEITKONTINUIERLICHE DATENÜBERTRAGUNG**
TRANSMISSION CONFIGURATION FOR CONTINUOUS-TIME DATA TRANSMISSION
ENSEMBLE EMETTEUR PERMETTANT LA TRANSMISSION DE DONNEES EN CONTINU

(30) Priorität: 21.12.2001 DE 10163466
(43) Veröffentlichungstag der Anmeldung: 15.09.2004
(73) Patentinhaber: Infineon Technologies AG, 81669 München (DE)
(72) Erfinder: BOOS, Zdravko, 81827 München (DE)
(74) Vertreter: Epping Hermann & Fischer
(86) Internationale Anmeldenummer: PCT/DE2002/004624
(87) Internationale Veröffentlichungsnummer: WO 2003/056739

(56) Entgegenhaltungen:
- WO-A-98/26503
- GB-A- 2 344 007
- US-A- 5 708 681
- US-A- 5 745 480

## Beschreibung

Die vorliegende Erfindung betrifft eine Sendeanordnung für eine zeitkontinuierliche Datenübertragung.

Während bei Mobilfunkgeräten der zweiten Generation nicht zeitkontinuierlich, sondern in Zeitfenstern, sogenannten Bursts, gesendet wird, verwenden moderne Übertragungsverfahren, beispielsweise gemäß Universal Mobile Telecommunications System(UMTS)-Standard, zeitkontinuierliche Übertragungsverfahren.

Im UMTS-Standard ist als Vielfachzugriffsverfahren der Einsatz von Code Division Multiple Access, CDMA, vorgesehen. Dabei muß der Mobilfunksender in der Lage sein, ohne Unterbrechung zeitkontinuierlich zu senden. Derartige Mobilfunkgeräte müssen zudem sehr strengen Anforderungen an den Regelungsbereich der Sendeleistung und damit den Regelungsbereich der Leistungsverstärker sowie außerdem der Genauigkeit der Verstärkungsregelung genügen. Dadurch unterscheiden sie sich signifikant von den bisher, beispielsweise bei GSM, Global System for Mobile Communication, eingesetzten Kombinationen von Zeit- und Frequenzvielfachzugriffsverfahren, englisch TDMA, Time Division Multiple Access, und FDMA, Frequency Division Multiple Access.

UMTS-Mobilfunkgeräte müssen in der Lage sein, die Sendeleistung während einer Datenübertragung laufend an die sich ändernden Gegebenheiten anzupassen. Die Sendeleistung kann dabei von der aktuellen Empfangsfeldstärke des Mobilteils abhängen oder von einer Feststation vorgegeben werden.

Da bei derartigen CDMA-Geräten zusätzlich zur Leistungsregelung während einer laufenden Datenübertragung bestimmte Anforderungen an die Größe von Fehlervektoren und an das Sendefrequenzspektrum über den gesamten, dynamischen Bereich hinweg zu erfüllen sind, weisen derzeit bekannte Mobilfunkgeräte, die für zeitkontinuierliche Datenübertragung ausgelegt sind, eine automatische Verstärkungsregelung, Automatic Gain Control, AGC, auf, welche sich dadurch auszeichnet, daß das Steuersignal für die verwendeten AGC-Bauteile ein wertkontinuierliches Analogsignal ist. Somit ist sichergestellt, daß die Sendeleistung während des ununterbrochenen Sendebetriebs nachgeregelt werden kann, ohne Grenzwerte der jeweiligen Standards zu verletzen.

Die Ansteuerung derartiger AGC-Bauteile hat jedoch den Nachteil eines verhältnismäßig großen Strombedarfs für die erforderlichen Digital/Analog-Wandler, erfordert zusätzliche Chipfläche, führt zu verhältnismäßig großer Störanfälligkeit der analogen Steuersignale und bedeutet damit insgesamt verhältnismäßig hohe Kosten für den Entwurf und die Fertigung derartiger Geräte.

In der Druckschrift US 5,708,681 ist ein Funk-Sende-Empfänger angegeben, bei dem im Sendezweig ein Leistungsverstärker vorgesehen ist, der einem Quadratur-Modulator nachgeschaltet ist. Die Sendeleistung wird über einen Steuerblock beeinflusst, der die Verstärkung des Leistungsverstärkers steuert in Abhängigkeit von einem digital vorliegenden Steuersignal.

Aufgabe der vorliegenden Erfindung ist es, eine Sendeanordnung für eine zeitkontinuierliche Datenübertragung anzugeben, welche für UMTS geeignet und bezüglich der Stromaufnahme verbessert ist.

Erfindungsgemäß wird die Aufgabe gelöst durch eine Sendeanordnung für zeitkontinuierliche Datenübertragung, aufweisend
- eine Basisband-Signalverarbeitungseinheit, ausgelegt für komplexwertige Signalverarbeitung, mit einem Inphase- und einem Quadratur-Signalpfad,
- einen Quadratur-Modulator mit einem ersten Eingang, der mit dem Inphase-Signalpfad gekoppelt ist, mit einem zweiten Eingang, der mit dem Quadratur-Signalpfad gekoppelt ist, und mit einem Ausgang,
- einen Hochfrequenzzweig, der mit dem Ausgang des Quadratur-Modulators gekoppelt ist,
- eine Steuereinheit, die ein wertdiskretes Steuersignal zur Beeinflussung der Sendeleistung der Sendeanordnung bereitstellt,
- einen ersten programmierbaren Verstärker, der in der Basisband-Signalverarbeitungseinheit zur Verstärkung des zu sendenden Nutzsignals mit einem einstellbaren Verstärkungsfaktor angeordnet ist, mit einem Steuereingang, der mit der Steuereinheit zur Übermittlung des wertdiskreten Steuersignals gekoppelt ist, umfassend einen im Inphase-Signalpfad angeordneten Teilverstärker und einen im Quadratur-Signalpfad angeordneten Teilverstärker, und
- einen zweiten programmierbaren Verstärker, der im Hochfrequenzzweig angeordnet ist, umfassend einen Steuereingang, der mit der Steuereinheit zur Übermittlung eines wertdiskreten Steuersignals gekoppelt ist, und
- einen Rückkopplungspfad umfassend ein Mittel zur Trägerfrequenzunterdrückung , mit einem Eingang, der mit dem Ausgang des Quadratur-Modulators gekoppelt ist, und mit einem Ausgang, der mit dem Inphase- und mit dem Quadratur-Signalpfad gekoppelt ist.

Der Gegenstand des Anspruchs 1 dadurch unterscheidet von US-A-5 708 681 dadurch, daß vor dem Quadratur-Modulator eine aktive Verstärkung durchgeführt wird, und in einem Rückkopplungspfad ein Mittel zur Trägerfrequenzunterdrückung vorgesehen ist, mit einem Eingang, der mit dem Ausgang des Quadratur- Modulators gekoppelt ist, und mit einem Ausgang, der mit dem Inphase-und mit dem Quadratur-Signalpfad gekoppelt ist.

Gemäß vorliegendem Prinzip wird zur Beeinflussung der Sendeleistung der Sendeanordnung zumindest ein programmierbarer Verstärker eingesetzt, der mit einem wertdiskreten Steuersignal angesteuert wird. Im Unterschied zu den üblicherweise verwendeten Automatic Gain Control(AGC)-Reglern, welche mit wertkontinuierlichen Analogsignalen zur Verstärkungsregelung angesteuert werden, erfolgt bei dem vorliegenden, programmierbaren Verstärker die Ansteuerung mit einem wertdiskreten Steuersignal für die Regelung der Amplitudenverstärkung in der Sendeanordnung.

Gemäß der vorliegenden Erfindung ist des weiteren eine Rückkopplungsschleife zur Trägerfrequenzunterdrückung vorgesehen, mit einem Rückkopplungspfad, der den Ausgang des Quadratur-Modulators mit seinem Inphase- und seinem Quadratur-Signaleingang koppelt. Eine derartige Rückkopplungsschleife kann beispielsweise Frequenzanteile bei der Trägerfrequenz, welche als Störsignale am Ausgang des Modulators auftreten, in ihrer Amplitude detektieren und auf die am Eingang des Quadratur-Modulators zuführbaren Signalkomponenten bezüglich von Gleichspannungsoffsets zwischen den symmetrischen Komponenten in Inphase-Zweig und /oder Quadratur-Zweig so einwirken, daß die Trägerfrequenz verschwindet oder möglichst gering ist.

Dem vorliegenden Prinzip zum Aufbau einer Sendeanordnung für zeitkontinuierliche Datenübertragung liegt die Erkenntnis zugrunde, daß bei der zeitkontinuierlichen Datenübertragung bei gleichzeitiger Erfüllung von Spezifikationsgrenzwerten, insbesondere in Bezug auf das hochfrequente Spektrum und die Größe von Fehlervektoren, dennoch auf eine wertkontinuierlich angesteuerte, automatische Verstärkungsregelung verzichtet werden kann.

Da in den digitalen Signalprozessoren im Basisband einer derartigen Sendeanordnung ohnehin üblicherweise die Steuerspannung für die Verstärkungsregelung digital, das heißt zeitund wertdiskret vorliegt, kann mit vorliegendem Prinzip vorteilhafterweise auf Digital/Analog-Wandler verzichtet werden. Ein derartiges Spannungssignal wird in der Basisband-Signalverarbeitungseinheit üblicherweise in Abhängigkeit von der aktuellen Empfangsfeldstärke, dem sogenannten Received Signal Strength Indicator, RSSI, abgeleitet. Mit dem D/A-Wandler können auch nachgeschaltete Filter zur Rekonstruktion des analogen Steuersignals entfallen.

Das Entfallen der D/A-Wandler bringt einen signifikant geringeren Strombedarf mit sich sowie zusätzlich eine deutliche Verringerung der benötigten Chipfläche für die Basisband-Signalverarbeitungseinheit, die beispielsweise in einem Basisband-IC (Integrated Circuit) integriert sein kann.

Das digitale Datenformat des Steuersignals hat den zusätzlichen Vorteil, daß eine Verbesserung der Störanfälligkeit gegenüber einem Analogsignal erzielt ist.

Bei geeigneter Auslegung kann auch die Genauigkeit der Sendeleistungsregelung, beispielsweise in einem Mobilteil, in dem die Sendeanordnung vorgesehen ist, deutlich erhöht werden. Mit der gemäß vorliegendem Prinzip möglichen, ausschließlich digitalen Signalverarbeitung des Steuersignals zur Beeinflussung der Sendeleistung, beispielsweise in Abhängigkeit von der aktuellen Empfangsfeldstärke und von Vorgabesignalen einer Basisstation, ist dieses Steuersignal unempfindlich gegenüber Temperatureinflüssen, Substrat-Rauschen, welches die D/A-Konverter beeinflussen würde, Schwankungen der Betriebsspannung sowie Fertigungsschwankungen. Bei einem für komplexwertige Signalverarbeitung ausgelegten Sender, bei dem die Anforderungen an die Paarungstoleranzen der in den komplementären Signalzweigen verwendeten Bauteile sehr hoch sind, ist ein zusätzlicher Vorteil durch Einsetzen einer wertdiskreten Ansteuerung des programmierbaren Verstärkers erzielt.

Schließlich führen die vorteilhaften Eigenschaften des vorliegenden Prinzips wie Reduzierung der Chipfläche, Erhöhung der Robustheit gegenüber Interferenzen und anderen Umwelteinflüssen, die Reduzierung der Zahl der erforderlichen Pins an den ICs sowie die Leistungsreduzierung zusätzlich zu einer deutlichen Kostenreduzierung. Diese wiederum begünstigt die im vorliegenden Segment übliche Massenherstellung.

Gemäß dem beschriebenen Prinzip ist neben dem als erstem programmierbaren Verstärker ausgeführten programmierbaren Verstärker ein zusätzlicher zweiter programmierbarer Verstärker vorgesehen, von denen je einer in der Basisband-Signalverarbeitungseinheit und einer im Hochfrequenzzweig angeordnet ist. Der im Basisband angeordnete, erste programmierbare Verstärker ist dabei selbstverständlich sowohl im Inphase- als auch im Quadratur-Signalzweig vorgesehen.

Die beschriebenen, programmierbaren Verstärker werden jeweils mit einem wertdiskreten Steuersignal angesteuert.

Die Verteilung der Signalverstärkung auf Basisband und Hochfrequenzzweig ermöglicht eine besonders große Flexibilität bei der Auslegung der Verstärkungsstufen und bei der Anpassung des Timings. Zusätzlich ergibt sich mit Vorteil die Möglichkeit, Basisband-ICs und Hochfrequenz-ICs verschiedener Typen oder Hersteller kombinieren zu können.

Da gemäß UMTS-Spezifikation mit Klasse 3-Geräten ein Verstärkungs-Regelungsbereich im Sender von mindestens 74 dB vorgesehen ist, kann dieser hohe Dynamikbereich vorteilhafterweise auf zwei Verstärkerstufen, je eine im Basisband und im Hochfrequenzzweig angeordnet, verteilt werden.

Bevorzugt kann in demjenigen, programmierbaren Verstärker, der im Basisband angeordnet ist, eine Verstärkung von mit einem Dynamikumfang von 20 bis 30 dB erfolgen, während die Verstärkung im Hochfrequenzzweig bevorzugt einen Dynamikumfang von 50 bis 60 dB hat.

Die Sendeanordnung kann bevorzugt in der Basisband-Signalverarbeitungseinheit oder im Hochfrequenz-Zweig einen passiven, programmierbaren Verstärker aufweisen, mit einem Steuereingang, der mit der Steuereinheit zur Bereitstellung einer wertdiskreten Signaldämpfung gekoppelt ist.

Der passive, programmierbare Verstärker kann als Widerstandsnetzwerk ausgeführt sein.

Der passive, programmierbare Verstärker dämpft das zu sendende Signal. Die Dämpfung ist dabei in wertdiskreten Schritten einstellbar. Mit einer derartigen, passiven Regelung ist eine Reduzierung der Stromaufnahme sowie ein lediglich geringes Substratrauschen ohne Verringerung des Dynamikbereichs des Senders erzielbar.

Der passive, programmierbare Verstärker ist bevorzugt am Ausgang des Quadratur-Modulators angeschlossen.

Der passive, programmierbare Verstärker am Ausgang des Quadratur-Modulators ist bevorzugt einem aktiven, programmierbaren Verstärker vorgeschaltet.

Bevorzugt ist der passive, programmierbare Verstärker in Schritten von 6 dB einstellbar. Der erste, aktive, programmierbare Verstärker in der Basisband-Signalverarbeitungseinheit ist bevorzugt in Schritten von 1 dB einstellbar. Der zweite, aktive, programmierbare Verstärker im Hochfrequenz-Zweig ist bevorzugt in Schritten von 6 dB einstellbar.

Um den Strombedarf der Sendeanordnung weiter zu verringern, umfaßt der programmierbare Verstärker mehrere, parallel geschaltete und unabhängig voneinander zu- und abschaltbare Verstärkerzweige, wobei das Zu- und Abschalten der Verstärkerzweige in Abhängigkeit von dem wertdiskreten Steuersignal erfolgt.

Die jeweils nicht benötigten Verstärkerzweige können abgeschaltet, das heißt deren Stromquellen deaktiviert werden, so daß der Strombedarf des programmierbaren, aktiven Verstärkers oder der programmierbaren Verstärker sinkt. Da normalerweise eine Sendeanordnung, beispielsweise im Mobilfunk, den Großteil der Betriebszeit nicht mit maximaler Sendeleistung arbeitet, ist mit der beschriebenen Aufteilung des programmierbaren Verstärkers auf mehrere, unabhängig voneinander zu- und abschaltbare Zweige, eine deutliche Reduzierung der Stromaufnahme möglich.

Gemäß einer weiteren, bevorzugten Ausführungsform der vorliegenden Erfindung weist der programmierbare Verstärkung ein Mittel zum Einstellen der Anstiegszeit des Verstärkungsfaktors auf.

Das Mittel zum Einstellen der Anstiegszeit ermöglicht, daß beim Umschalten des programmierbaren Verstärkers von einer Verstärkerstufe auf eine andere Verstärkerstufe kein sprunghaftes Verändern des Verstärkungsfaktors erfolgt, sondern ein weicher Übergang möglich ist. Hierdurch werden unerwünschte, hochfrequente Signalanteile beim Umschalten deutlich verringert und zudem auch die Amplitude des Fehlervektors beim Umschalten verringert.

Das Steuersignal zum Ansteuern eines derart weitergebildeten, programmierbaren Verstärkers ist dabei weiterhin ein wertdiskretes Steuersignal.

Die Sendeanordnung ist bevorzugt in einem Mobilfunksender vorgesehen.

Weitere Einzelheiten und vorteilhafte Ausgestaltungen der vorliegenden Erfindung sind Gegenstand der Unteransprüche.

Nachfolgend wird die Erfindung an mehreren Ausführungsbeispielen anhand der Zeichnungen näher erläutert.

Es zeigen:
- Figur 1: ein vereinfachtes Blockschaltbild mit ausgewählten Bauteilen einer Sendeanordnung,
- Figur 2: eine Weiterbildung der Sendeanordnung von Figur 1 mit Trägerfrequenzunterdrückung gemäß vorliegendem Prinzip, und
- Figur 3: ein vereinfachtes Schaltbild eines beispielhaften, programmierbaren Verstärkers zum Einsatz in Sendeanordnungen gemäß Figuren 1 oder 2.

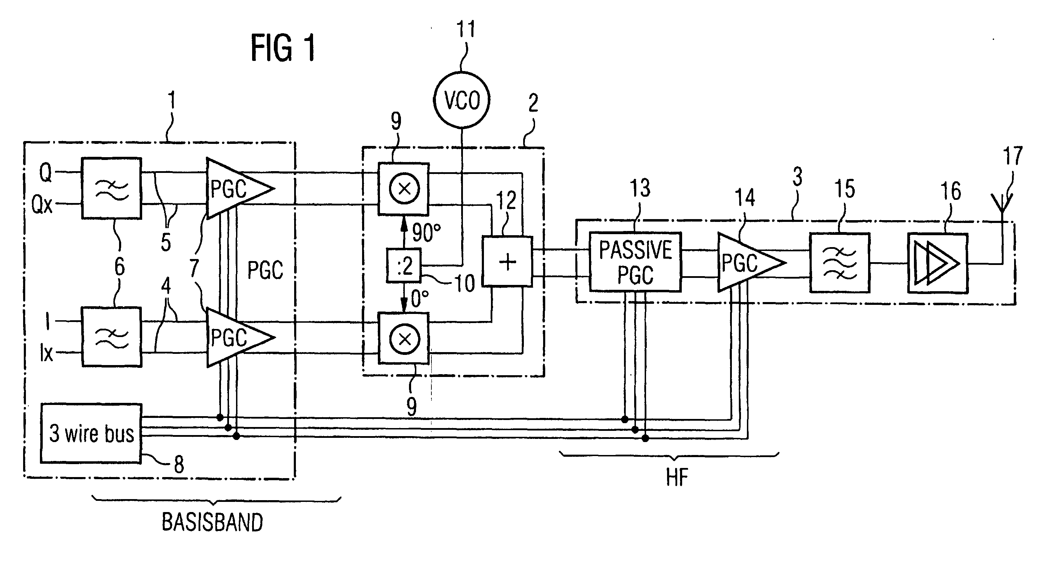

Figur 1 zeigt eine Sendeanordnung ausgelegt für zeitkontinuierliche Datenübertragung. Diese umfaßt eine Basisband-Signalverarbeitungseinheit 1, einen Quadraturmodulator 2 und einen Hochfrequenzzweig 3. Die Basisband-Signalverarbeitungseinheit 1 ist für komplexwertige Signalverarbeitung ausgelegt und umfaßt hierfür einen Inphase-Zweig 4 und einen Quadratur-Signalpfad 5. Inphase- und Quadratur-Signalpfad 4, 5 sind jeweils zur Übertragung symmetrischer Signale ausgebildet. Inphase- und Quadratur-Signalpfad 4, 5 weisen je ein TiefpaßFilter 6 auf, denen je ein erster programmierbarer Verstärker 7 nachgeschaltet ist. Die ersten programmierbaren Verstärker 7 weisen je einen Steuereingang zum Zuführen eines wertdiskreten Steuersignals auf, der mit dem Ausgang einer Steuereinheit 8 über einen digitalen Dreileiterbus gemäß der 3Wire-Bus-Spezifikation verbunden ist. An die Ausgänge der ersten programmierbaren Verstärker 7 ist ein Quadratur-Modulator 2 angeschlossen. Der Quadratur-Modulator 2 umfaßt zwei Gilbert-Multiplizierer 9, die mit ihrem ersten Eingangspaar mit je einem Ausgang je eines ersten programmierbaren Verstärkers 7 verbunden sind und deren zweites Eingangspaar über einen 0 Grad/90 Grad-Frequenzteiler 10 an einen spannungsgesteuerten Oszillator 11 zur Bereitstellung eines komplexwertigen Signals mit einer Trägerfrequenz angeschlossen ist. Die Ausgänge der beiden Gilbert-Multiplizierer 9 sind an je ein Eingangspaar eines Summierknotens 12 angeschlossen, dessen Ausgang den Ausgang des Quadratur-Modulators 2 bildet. An den Ausgang des Quadratur-Modulators 2 ist der Hochfrequenzzweig 3 angeschlossen, der einen passiven, programmierbaren Verstärker 13, einen zweiten programmierbaren Verstärker 14, ein Bandpaßfilter 15 und einen Leistungsverstärker 16 umfaßt. Der Leistungsverstärker 16 weist einen Ausgang auf, der zugleich den Ausgang des Hochfrequenz-Zweiges 3 bildet und der an eine Antenne 17 angekoppelt ist. Der passive, programmierbare Verstärker 13 ist mit seinem Eingang an den symmetrisch ausgebildeten Ausgangs des Summierknotens 12 angeschlossen. Der Ausgang des passiven, programmierbaren Verstärkers 13 ist mit dem Eingang des zweiten programmierbaren Verstärkers 14, der ein aktiver Verstärker ist, verbunden. An den Ausgang des zweiten programmierbaren Verstärkers 14 ist ein Bandpaßfilter 15 angeschlossen. Der Ausgangs des Bandpaßfilters 15 ist mit einem Eingang des Leistungsverstärkers 16 gekoppelt. Sowohl der passive, programmierbare Verstärker 13, als auch der zweite programmierbare Verstärker 14 sind zu ihrer Steuerung mit der Steuereinheit 8 über den Drei-Leiter-Bus verbunden.

Die beschriebene Sendeanordnung für zeitkontinuierliche Datenübertragung ist demnach als Homodyn-Sender oder Direktumsetzer ausgebildet.

Die Ansteuerung der programmierbaren Verstärker 7, 13, 14 durch die Steuereinheit 8 erfolgt mittels wertdiskreter Signale. Die Sendeanordnung ist für eine zeitkontinuierliche Datenübertragung gemäß CDMA ausgelegt und als UMTS-Sender ausgebildet. Bei derartigen Mobilfunkgeräten gemäß UMTS-Standard ist normalerweise neben dem gezeigten Sendezweig zusätzlich ein in Figur 1 nicht dargestellter Empfangszweig zur Bildung eines Transceivers vorgesehen.

Die gesamte, regelbare Verstärkung der Sendeanordnung ist zum Erzielen eines großen Dynamikumfangs auf zwei aktive, programmierbare Verstärkerstufen 7, 14 und eine passive, programmierbare Verstärkerstufe 13 verteilt. Dabei wird in der Basisband-Signalverarbeitungseinheit 1 eine Verstärkungsregelung im Umfang von ca. 20 bis 30 dB erzielt, während im Hochfrequenz-Zweig 3 ein Dynamikumfang von ca. 50 bis 60 dB als Regelbereich vorgesehen ist. Da am Ausgang des Quadratur-Modulators vorteilhafterweise ein Leistungspegel von ca. -10 dBm vorherrschen soll, muß am Ausgang des Quadratur-Modulators 2 ein Verstärkungsregelungsbereich von ca. +15 bis -45 dB vorgesehen sein. Dies erlaubt mit Vorteil die Verwendung einer passiven, programmierbaren Verstärkungsstufe 13, welche im vorliegenden Ausführungsbeispiel als steuerbares Widerstandsnetzwerk ausgeführt ist. Im beschriebenen Ausführungsbeispiel sind der passive, programmierbare Verstärker 13 und der zweite programmierbare Verstärker 14 jeweils in Schritten von 6 dB verstellbar. Der erste programmierbare Verstärker 7 im Basisband ist in diskreten Schritten von 1 dB verstellbar. Die Verstärkungsfaktoren der Verstärker 7, 13, 14 sind also nicht, wie üblicherweise bei kontinuierlichen Datenübertragungssystemen vorgesehen, wertkontinuierlich, sondern wertdiskret einstellbar. Durch die beschriebene Kombination von Basisband- und Hochfrequenz-Verstärkungsregelung kann insgesamt eine Auflösung der Verstärkungsregelung von 1 dB durch geeignete Ansteuerung Verstärker 7, 13, 14 mittels der Steuereinheit 8 und wertdiskreten Steuersignalen erzielt werden.

Trotz der wertdiskreten Verstärkungsregelung ist es mit vorliegender Sendeanordnung möglich, die bei CDMA-Sendern vorgeschriebenen Anforderungen bezüglich des hochfrequenten Spektralgehalts der Sendesignale und der erforderlichen Größe der Fehlervektoren einzuhalten. Dies wird dadurch noch erleichtert, daß die programmierbaren Verstärker 13, 14 eine einstellbare Anstiegszeit bezüglich ihrer Impulse haben. Die Anstiegszeit im Basisband ist inhärent länger, wenn Basisbandfilter vorgesehen sind. Im Hochfrequenzzweig jedoch ist eine steuerbare Anstiegszeit derart vorgesehen, daß diese mit der Anstiegszeit der Verstärker im Basisband übereinstimmt. Somit ist insgesamt ein problemloses Erfüllen der bei UMTS auf 17,5% begrenzten Fehlervektorgröße ermöglicht.

Die Sendeanordnung gemäß beschriebenem Ausführungsbeispiel ist sowohl in Mobilfunksystemen der zweiten Mobilfunkgeneration mit CDMA, der dritten Generation sowie außerdem in kommenden Generationen von Mobilfunksystemen, wie beispielsweise der geplanten vierten Generation, einsetzbar.

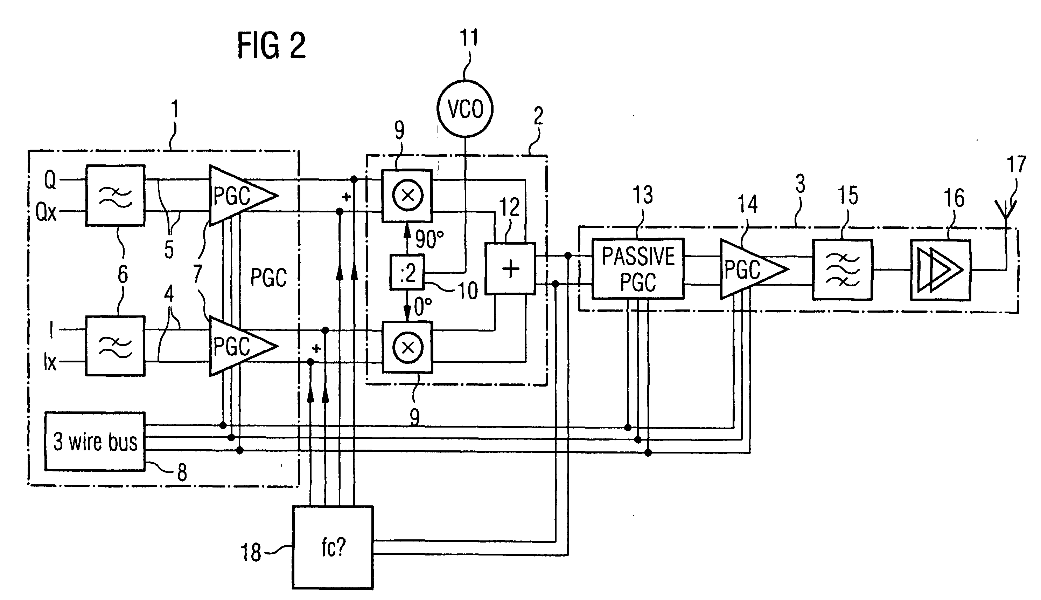

Figur 2 zeigt eine Weiterbildung der Sendeanordnung von Figur 1 mit einer zusätzlichen Vorrichtung zur Trägerfrequenzunterdrückung 18, die den Ausgang des Quadratur-Modulators 2 mit seinen Quadratur-Eingängen koppelt. Abgesehen von dieser Weiterbildung entspricht die Sendeanordnung von Figur 2 in ihren verwendeten Bauteilen, deren Zusammenschaltung, ihren Funktionen und dem vorteilhaften Zusammenwirken der Bauteile der Sendeanordnung von Figur 1, deren Beschreibung daher an dieser Stelle nicht wiederholt wird.

Die zusätzliche Schleife zur Trägerfrequenzunterdrückung umfaßt einen Rückkopplungspfad, der das Mittel zur Trägerfrequenzunterdrückung 18 umfaßt und der mit seinem symmetrisch ausgebildeten Eingang an den Ausgang des Summierknotens 12 angeschlossen ist. Am Ausgang des Mittels zur Trägerunterdrückung 18 sind zwei Ausgangsklemmenpaare vorgesehen, die jeweils mit den Eingängen der Gilbert-Mischer 9 an deren symmetrischen Eingangspaaren gekoppelt sind, beispielsweise wie in Figur 2 dargestellt mittels Addierknoten, die an weiteren Eingängen mit den Ausgängen der programmierbaren Verstärker 7 verbunden sind.

Das Mittel zur Trägerfrequenzunterdrückung 18 detektiert gegebenenfalls am Ausgang des Quadratur-Modulators 2 durchscheinende Anteile der vom VCO 11 bereitgestellten Trägerfrequenz, englisch Carrier Frequency, und beeinflußt in deren Abhängigkeit die Inphase- und Quadratur-Komponenten der Basisbandsignale in den Signalpfaden 4 und 5. Dabei kann beispielsweise ein zusätzlicher Gleichspannungsoffset innerhalb der Symmetriekomponenten von Inphase-Zweig 4 oder innerhalb der Symmetriekomponenten von Quadratur-Zweig 5 oder beiden eingeführt werden.

Das Vorsehen einer Trägerfrequenzunterdrückungsschleife ist insbesondere in Kombination mit den programmierbaren Verstärkern 7 vorteilhaft, welche gegebenenfalls zu einem verstärkten Auftreten von Frequenzanteilen bei der Trägerfrequenz am Ausgang des Quadratur-Modulators 2 führen können.

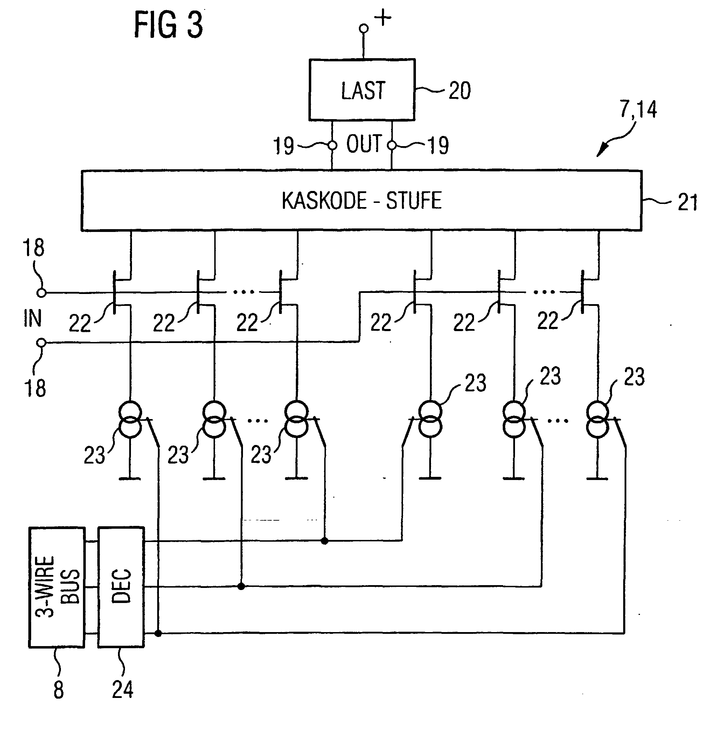

Figur 3 zeigt beispielhaft den Aufbau eines programmierbaren Verstärkers mit einer Vielzahl von unabhängig voneinander zuund abschaltbaren Verstärkerzweigen, der als erster und/oder zweiter programmierbarer Verstärker 7, 14 in den Sendeanordnungen gemäß Figuren 1 und 2 mit Vorteil einsetzbar ist.

Im Einzelnen umfaßt der programmierbare Verstärker gemäß Figur 3, der in symmetrischer Schaltungstechnik aufgebaut ist, einen Signaleingang 18 und einen Signalausgang 19, an dem eine elektrische Last 20 angeschlossen ist. Der Verstärker umfaßt drei parallel geschaltete, symmetrische Verstärkerzweige, die jeweils von einer Serienschaltung aus einer Kaskode-Stufe 21, einem Feldeffekttransistor 22 und einer Stromquelle 23 gebildet sind. Die Transistoren 22 sind jeweils paarweise einander zugeordnet und an ihren Steuereingängen paarweise mit dem Signaleingang 18 verbunden. Die Stromquellen 23 sind ebenfalls paarweise einander zugeordnet und weisen jeweils Steuereingänge zum Zu- und Abschalten der Stromquellen 23 paarweise unabhängig voneinander auf, die mit der Steuereinheit 8 gekoppelt sind. Die Steuereinheit 8 stellt dabei ein wertdiskretes, digitales Signal zur Verstärkungsregelung über einen Drei-Leiter-Bus bereit. Die Kopplung der Steuereingänge der Stromquellen 23 mit der Steuereinheit 8 erfolgt über einen Decoder 24, der das vom 3-Leiter-Bus an seinem Eingang zugeführte, serielle Signal in ein paralleles Signal konvertiert, welches an seinem Ausgang bereitsteht.

Anstelle der gezeigten drei Paare von Verstärkerzweigen 21, 22, 23 können beliebig viele Verstärkerzweige vorgesehen sein, beispielsweise 16 Verstärkerzweigpaare 21, 22, 23. Wie bereits eingangs erläutert, ermöglicht das Abschalten der für die aktuelle Sendeleistung nicht benötigten Verstärkerzweige eine deutliche Stromreduzierung der Sendeanordnung und damit bei Einsatz der Sendeanordnung in tragbaren Mobilfunkgeräten eine deutlich längere Akku-Betriebszeit beziehungsweise Sprechzeit.

Alternativ zu den in den Ausführungsbeispielen vorgesehenen Abstufung der Verstärkungs- und Dämpfungsschritten von 1 dB bzw. 6 dB kann in Abhängigkeit der Anwendung auch jede andere Kombination der Schrittweiten, solange die Schrittweite diskret abgestuft ist, vorgesehen sein.

### Bezugszeichenliste

- 1: Basisband-Signalverarbeitungseinheit
- 2: Quadratur-Modulator
- 3: Hochfrequenz-Zweig
- 4: Inphase-Signalpfad
- 5: Quadratur-Signalpfad
- 6: Tiefpaßfilter
- 7: erster programmierbarer Verstärker
- 8: Steuereinheit
- 9: Mischer
- 10: 0 Grad / 90 Grad-Teiler
- 11: spannungsgesteuerter Oszillator
- 12: Summierknoten
- 13: passiver, programmierbarer Verstärker
- 14: zweiter programmierbarer Verstärker
- 15: Bandpaßfilter
- 16: Leistungsverstärker
- 17: Antenne
- 18: Signaleingang
- 19: Signalausgang
- 20: Last
- 21: Kaskode-Stufe
- 22: Transistor
- 23: Stromquelle
- 24: Decoder
- I: Inphase-Signalkomponente
- Q: Quadratur-Signalkomponente

## Patentansprüche

1. Sendeanordnung für zeitkontinuierliche Datenübertragung, aufweisend:
- eine Basisband-Signalverarbeitungseinheit (1), ausgelegt für komplexwertige Signalverarbeitung eines zu sendenden Nutzsignals, mit einem Inphase- und einem Quadratur-Signalpfad (4, 5),
- einen Quadratur-Modulator (2) mit einem ersten Eingang, der mit dem Inphase-Signalpfad (4) gekoppelt ist, mit einem zweiten Eingang, der mit dem Quadratur-Signalpfad (5) gekoppelt ist, und mit einem Ausgang,
- einen Hochfrequenzzweig (3), der mit dem Ausgang des Quadratur-Modulators (2) gekoppelt ist,
- eine Steuereinheit (8), die ein wertdiskretes Steuersignal zur Beeinflussung der Sendeleistung der Sendeanordnung bereitstellt,
- einen ersten programmierbaren Verstärker (7), der in der Basisband-Signalverarbeitungseinheit (1) zur Verstärkung des zu sendenden Nutzsignals mit einem einstellbaren Verstärkungsfaktor angeordnet ist, mit einem Steuereingang, der mit der Steuereinheit (8) zur Übermittlung des wertdiskreten Steuersignals gekoppelt ist, umfassend einen im Inphase-Signalpfad (4) angeordneten Teilverstärker und einen im Quadratur-Signalpfad (5) angeordneten Teilverstärker,
- einen zweiten programmierbaren Verstärker (14), der im Hochfrequenzzweig (3) angeordnet ist, umfassend einen Steuereingang, der mit der Steuereinheit (8) zur Übermittlung eines wertdiskreten Steuersignals gekoppelt ist, und
- einen Rückkopplungspfad umfassend ein Mittel zur Trägerfrequenzunterdrückung (18), mit einem Eingang, der mit dem Ausgang des Quadratur-Modulators (2) gekoppelt ist, und mit einem Ausgang, der mit dem Inphase- und mit dem Quadratur-Signalpfad (4, 5) gekoppelt ist.

2. Sendeanordnung nach Anspruch 1,
**dadurch gekennzeichnet, daß**
in der Basisband-Signalverarbeitungseinheit (1) oder im Hochfrequenzzweig (3) ein passiver, programmierbarer Verstärker (13) zur Verarbeitung des zu sendenden Nutzsignals vorgesehen ist, mit einem Steuereingang, der mit der Steuereinheit (8) zur Bereitstellung einer wertdiskreten Signaldämpfung gekoppelt ist.

3. Sendeanordnung nach Anspruche 1 oder 2,
**dadurch gekennzeichnet, daß**
der erste und/oder der zweite programmierbare Verstärker (7, 14) mehrere, parallel geschaltete und unabhängig voneinander zu- und abschaltbare Verstärkerzweige (21, 22, 23) umfaßt, wobei das Zu- und Abschalten der Verstärkerzweige (21, 22, 23) in Abhängigkeit von dem wertdiskreten Steuersignal erfolgt.

4. Sendeanordnung nach einem der Ansprüche 1 bis 3,
**dadurch gekennzeichnet, daß**
der zweite programmierbare Verstärker (14) ein Mittel zum Einstellen der Anstiegszeit des Verstärkungsfaktors aufweist.

5. Sendeanordnung nach einem der Ansprüche 1 bis 4,
**dadurch gekennzeichnet, daß**
die Sendeanordnung ein Mobilfunksender ist.

## Claims

1. A transmission arrangement for transmitting data continuously in the time domain, having:
- a baseband signal processing unit (1), designed for complex-value signal processing for a useful signal which is to be transmitted, having an inphase and a quadrature signal path (4, 5),
- a quadrature modulator (2) having a first input, which is coupled to the inphase signal path (4), having a second input, which is coupled to the quadrature signal path (5), and having an output,
- a radiofrequency path (3), which is coupled to the output of the quadrature modulator (2),
- a control unit (8), which provides a discrete-value control signal for influencing the transmission power of the transmission arrangement,
- a first programmable amplifier (7), which is arranged in the baseband signal processing unit (1) in order to amplify the useful signal which is to be transmitted using an adjustable gain factor, having a control input which is coupled to the control unit (8) in order to transmit the discrete-value control signal, comprising an amplifier component which is arranged in the inphase signal path (4) and an amplifier component which is arranged in the quadrature signal path (5), and
- a second programmable amplifier (14), which is arranged in the radiofrequency path (3), comprising a control input which is coupled to the control unit (8) in order to transmit a discrete-value control signal, and
- a feedback path comprising a means for carrier frequency suppression (18), having an input which is coupled to the output of the quadrature modulator (2) and having an output which is coupled to the inphase and the quadrature signal path (4, 5).

2. The transmission arrangement as claimed in claim 1,
wherein
the baseband signal processing unit (1) or the radiofrequency path (3) contains a passive, programmable amplifier (13) in order to process the useful signal which is to be transmitted, having a control input which is coupled to the control unit (8) in order to provide discrete-value signal attenuation.

3. The transmission arrangement as claimed in claim 1 or 2,
wherein
the first and/or the second programmable amplifier (7, 14) comprises a plurality of parallel-connected amplifier paths (21, 22, 23) which can be connected and disconnected independently of one another, the amplifier paths (21, 22, 23) being connected and disconnected on the basis of the discrete-value control signal.

4. The transmission arrangement as claimed in one of claims 1 to 3,
wherein
the second programmable amplifier (14) has a means for setting the rise time of the gain factor.

5. The transmission arrangement as claimed in one of claims 1 to 4,
wherein
the transmission arrangement is a mobile radio transmitter.

## Revendications

1. Dispositif d'émission pour la transmission de données en continu dans le temps, comprenant :
- une unité (1) de traitement de signal en bande de base conçue pour le traitement à valeur complexe d'un signal utile à émettre, ayant un chemin (4) de signal en phase et un chemin (5) de signal en quadrature,
- un modulateur (2) en quadrature comprenant une première entrée qui est couplée au chemin (4) de signal en phase, une deuxième entrée qui est couplée au chemin (5) de signal en quadrature et une sortie,
- une branche (3) de haute fréquence, qui est couplée à la sortie du modulateur (2) en quadrature,
- une unité (8) de commande, qui met à disposition un signal de commande de valeur discrète pour influer sur la puissance d'émission du dispositif d'émission,
- un premier amplificateur (7) programmable qui est disposé dans l'unité (1) de traitement de signal en bande de base pour amplifier le signal utile à émettre d'un facteur d'amplification réglable, ayant une entrée de commande qui est couplée à l'unité (8) de commande pour la transmission du signal de commande à valeur discrète, comprenant un sous-amplificateur disposé dans le chemin (4) du signal en phase et un sous-amplificateur disposé dans le chemin (5) du signal en quadrature,
- un deuxième amplificateur (14) programmable qui est disposé dans la branche (3) haute fréquence, comprenant une entrée de commande qui est couplée à l'unité (8) de commande pour la transmission d'un signal de commande à valeur discrète, et
- un chemin de couplage en retour, comprenant un moyen de suppression (18) de la fréquence porteuse, ayant une entrée qui est couplée à la sortie du modulateur (2) en quadrature et une sortie qui est couplée au chemin (4) de signal en phase et au chemin (5) de signal en quadrature.

2. Dispositif d'émission suivant la revendication 1,
**caractérisé en ce qu'**il est prévu, dans l'unité (1) de traitement du signal en bande de base ou dans la branche (3) en haute fréquence, un amplificateur (13) programmable passif de traitement du signal utile à émettre, ayant une entrée de commande, qui est couplée à l'unité (8) de commande pour mettre à disposition une atténuation du signal à valeur discrète.

3. Dispositif d'émission suivant la revendication 1 ou 2,
**caractérisé en ce que** le premier et/ou le deuxième amplificateur (7, 14) programmable comprend plusieurs branches (21, 22, 23) d'amplificateur montées en parallèle et pouvant être branchées et débranchées indépendamment les unes des autres, le branchement et le débranchement des branches (21, 22, 23) d'amplificateur s'effectuant en fonction du signal de commande à valeur discrète.

4. Dispositif d'émission suivant l'une des revendications 1 à 3,
**caractérisé en ce que** le deuxième amplificateur (14) programmable comporte un moyen de réglage de la durée de montée du facteur d'amplification.

5. Dispositif d'émission suivant l'une des revendications 1 à 4,
**caractérisé en ce que** le dispositif d'émission est un émetteur téléphonique de téléphonie mobile.
